# EUROPEAN PATENT SPECIFICATION

(11) **EP 2 045 353 B1**
(45) Date of publication and mention of the grant of the patent: **14.12.2016**
(21) Application number: 07790796.2
(22) Date of filing: 13.07.2007
(51) Int. Cl.: C23C 14/35, H05H 1/46, H01J 37/34, H01J 37/32

(54) **Capacitive-coupled magnetic neutral loop plasma sputtering system**
Sputtersystem mit kapazitiv gekoppeltem Magnetneutralschleifenplasma
Système de pulvérisation plasma à boucle magnétique neutre à couplage capacitif

(30) Priority: 14.07.2006 JP 2006194105
(43) Date of publication of application: 08.04.2009
(73) Proprietor: ULVAC, INC., Chigasaki-shi, Kanagawa 253-8543 (JP)
(72) Inventor: ISHIKAWA, Michio, Susono-shi, Shizuoka 410-1231 (JP); HAYASHI, Toshio, Susono-shi, Shizuoka 410-1231 (JP)
(74) Representative: Schaumburg und Partner Patentanwälte mbB
(86) International application number: PCT/JP2007/064016
(87) International publication number: WO 2008/007784

(56) References cited:
- WO-A1-99/41425
- JP-A- 07 090 632
- JP-A- 07 263 189
- JP-A- 07 263 190
- JP-A- 08 225 967
- JP-A- 11 158 620
- JP-A- 2003 342 713
- JP-A- 2004 022 211
- JP-A- 2004 022 212
- JP-A- 2005 149 956
- JP-A- 2005 268 235
- TSUBOI H ET AL: "USEFULNESS OF MAGNETIC NEUTRAL LOOP DISCHARGE PLASMA IN PLASMA PROCESSING" JAPANESE JOURNAL OF APPLIED PHYSICS, JAPAN SOCIETY OF APPLIED PHYSICS, JP LNKD- DOI:10.1143/JJAP.34.2476, vol. 34, no. PART 01, 05A, 1 May 1995 (1995-05-01), pages 2476-2481, XP000670566 ISSN: 0021-4922

## Description

### Technical Field

This invention relates to a capacitive-coupled magnetic neutral loop (or neutral loop discharge-NLD) plasma sputtering system to be used for highly uniformly forming film on a large area substrate to manufacture electronic devices, semiconductor devices and functional thin films.

### Background Art

DC bias sputtering is being popularly employed as sputtering technique for forming metal thin films.

High-frequency bias and pulse bias DC sputtering systems are being employed for forming insulating films. Such sputtering systems utilize magnetron discharges due to the ExB drift phenomenon that can be made to appear by the magnetic field produced by a permanent magnet and a bias electric field for the purpose of raising the film forming rate of the sputtering system.

On the other hand, an ICP (inductively coupled plasma) type low pressure high density neutral loop plasma source designed to form a neutral loop by arranging three cylindrical coils outside a vacuum chamber and generate plasma along the neutral loop has been proposed (see Patent Document 1).

Patent Document 1: Jpn. Pat. Appln. Laid-Open Publication No. 07-090632

### Problem to Be Solved by the Invention

The most significant problem of magnetron sputtering is the use efficiency of target. Since magnetron sputtering utilizes the sputter produced by local high density plasma in ExB drift regions, the region of erosion is localized and the efficiency of utilization of target is limited if the magnet is driven to rotate. Additionally, there is a problem of damaging devices due to charge up because the lines of magnetic force are distributed in such a way that they have an oblique component relative to the substrate.

For these reasons, there has been a strong demand for uniform sputtering techniques using low pressure high density plasma, although no technique has been proposed to date to surpass magnetron sputtering. While the magnetron sputtering method is currently a state of the good film forming method, it is always accompanied by a problem that the use efficiency of target is lower than 50% and it is very difficult to arrange a magnetic field for uniform film formation.

On the other hand, while an ICP type plasma source can produce uniform and high density plasma, high-frequency power needs to be introduced into the vacuum barriers arranged near the antennas thereof so that the vacuum barriers arranged near the antennas need to be formed by using a dielectric. Therefore, such a plasma source cannot be applied to metal film formation. In other words, when an ICP type plasma source is employed for forming film by sputtering, metal film is formed on the inner surfaces of the dielectric barriers to shield the antenna electric fields for generating plasma so that the generated plasma cannot be sustained.

Additionally, a conventional plasma source that does not utilize any magnetic field requires a high discharge voltage. Then, sputtering particles collide with each other in a gas phase as large clusters, which then adhere to the surface to produce a coarse film.

In view of the above-identified technical problems of the prior art, it is therefore the object of the present invention to provide a capacitive-coupled magnetic neutral loop discharge plasma sputtering system having a structure that can uniformly sputter a target to dramatically raise the use efficiency of target and produce lines of magnetic force that are distributed uniformly so as not to produce any charge up.

A plasma sputtering system according to the preamble of claim 1 is disclosed in US 2003/0230985 A1.

### Means for Solving the Problem

According to the present invention, the above object is achieved by the plasma sputtering system of claim 1. The capacitive-coupled magnetic neutral loop or neutral loop discharge-NLD plasma sputtering
system includes: a vacuum chamber; a target placed in the vacuum chamber; a magnetic field generation means for forming a magnetic neutral loop of zero magnetic field in the vacuum chamber; and an electric field generation means for generating plasma along the magnetic neutral loop by applying a high-frequency bias to the target; the magnetic field gradient being set at 2 gauss/cm or above in the vicinity of the zero magnetic field of the magnetic neutral loop for sputtering the target by plasma and forming film on a substrate placed oppositely relative to the target.

In a capacitive-coupled magnetic neutral loop plasma sputtering system according to the present invention, the frequency of electric power applied to the electric field generation means may be not less than 13.56 MHz, preferably not less than 20 MHz.

Further, the magnetic field generation means may have three cylindrical coils so as to form a magnetic neutral loop at an arbitrarily selected position in the vacuum chamber by means of an arbitrarily selected magnetic field gradient.

The electric field generation means may have a conductive ceiling board fitted to the top edge of the vacuum chamber by way of an insulator to airtightly seal and ensure vacuum in the vacuum chamber and a high-frequency power source connected to said ceiling board to apply high-frequency power to said ceiling board.

In a capacitive-coupled magnetic neutral loop plasma sputtering system according to the present invention, the target may be a metal target.

A capacitive-coupled magnetic neutral loop plasma sputtering system according to the present invention may further comprise an RF power source connected to a substrate holder for placing the substrate in position and applying a bias to the substrate.

A capacitive-coupled magnetic neutral loop plasma sputtering system according to the present invention may further comprise a DC power source connected to the target placed in position in the system to superpose a DC voltage.

In a capacitive-coupled magnetic neutral loop plasma sputtering system according to the present invention, the DC power source may be connected to the ceiling board by way of a high-frequency filter.

A capacitive-coupled magnetic neutral loop plasma sputtering system according to the present invention may further comprise a low-frequency generation means connected to the target placed in position in the system to superpose a low-frequency bias onto the target.

In a capacitive-coupled magnetic neutral loop plasma sputtering system, the low-frequency generation means may have a low-frequency power source and a matching unit for connecting the low-frequency power source to the ceiling board.

A capacitive-coupled magnetic neutral loop plasma sputtering system according to the present invention may further comprise an anti-deposition member arranged in the vacuum chamber so as to surround the region between the target and the substrate.

### Advantages of the Invention

A capacitive-coupled magnetic neutral loop plasma sputtering system according to the present invention captures electrons in the vicinity of the zero magnetic field by means of a magnetic field gradient and efficiently accelerates electrons in a high-frequency electric field to generate high density plasma when the magnetic field gradient is set to 2 gauss/cm or above in the vicinity of the zero magnetic field of the magnetic neutral loop. As a result, the present invention provides an advantage that not only the target is sputtered uniformly to dramatically increase the use efficiency of the target but also lines of magnetic force are perpendicular relative to the substrate and distributed uniformly in the vicinity of the substrate to prevent any charge up from taking place.

When the frequency of electric power applied to the electric field generation means is increased above 13.56 MHz in order to raise the plasma density, electrons that are captured in the vicinity of the zero magnetic field due to the magnetic field gradient are increased to a large extent because of the raised plasma density so that the high-frequency electric field can be absorbed efficiently. Then, as a result, plasma can be obtained with a density level of 10¹¹ cm⁻³. For comparison, the plasma density that can be produced by magnetron is at the level of 10¹¹ cm⁻³ in the ExB drift area and at the level of 10¹⁰ cm⁻³ in areas (of a vertical magnetic field) remote from the ExB drift area to show remarkable density variances. However, the above-described arrangement according to the present invention can produce high density and uniform plasma. Therefore, while the use efficiency of target is less than 50% and maximally about 45% with magnetron sputtering, it can be as high as 50 to 70% according to the present invention.

Additionally, as a result of raising the efficiency of capturing electrons by means of a magnetic field by increasing the magnetic field gradient in the vicinity of the zero magnetic field and setting the frequency of the bias high-frequency power source at 20 MHz or above, a high efficiency is realized for absorption of high-frequency power by electrons to achieve a high density for CCP type NLD plasma that has hitherto been difficult to achieve so that the present invention find applications for metal sputtering systems.

Still additionally, as a result of using a cathode coupled plasma (CCP) source according to the present invention, it is no longer necessary to install an electric field generation means in a vacuum chamber unlike ICP plasma generators and not to form the wall of the vacuum chamber by using a dielectric. Thus, plasma can be generated without obstructing introduction of an electric field when forming metal film.

While the discharge pressure is 2Pa or above in ordinary cathode coupled plasma sources, electric discharges can be produced under pressure lower than 2Pa, or even lower than 1 Pa, by using NLD. As a result, the free path of sputtering particles is increased to make it possible to from fine film.

Furthermore, when an arrangement of adding a high-frequency power source to the target and connecting a DC power source or a low-frequency power source to the target for voltage superposition is adopted, the sputtering process can be controlled with ease because the bias applied to the target and the introduction of an electric field (high-frequency) can be controlled separately.

Finally, as a bias is applied to the substrate, plasma is generated around the substrate to raise the ionization ratio. The deposited film is hit by ions to make the film finer or raise the coverage.

### Brief Description of the Drawings

FIG 1 is a schematic illustration of an embodiment of capacitive-coupled magnetic neutral loop plasma sputtering system according to the present invention, showing the configuration thereof
FIG 2 is a schematic illustration of a magnetic potential contour map of the magnetic field produced in the vacuum chamber of the system of FIG 1.
FIG 3 is a graph illustrating the bias power dependency of the film forming rate of a system according to the present invention.
FIG 4 is a graph illustrating the relationship between the target-substrate distance and the film thickness distribution observed after forming film for 1 minute in a system according to the present invention.
FIG 5 is a graph illustration the dependency on the diameter of the magnetic neutral loop of the distribution of film deposition in a system according to the present invention.
FIG 6 is a schematic illustration of another embodiment of capacitive-coupled magnetic neutral loop plasma sputtering system according to the present invention, showing the configuration thereof.
FIG 7 is a schematic illustration of still another embodiment of capacitive-coupled magnetic neutral loop plasma sputtering system according to the present invention, showing the configuration thereof

### Best Mode for Carrying Out the Invention

Now, the present invention will be described by referring to the accompanying drawings that illustrate an embodiment of the present invention.

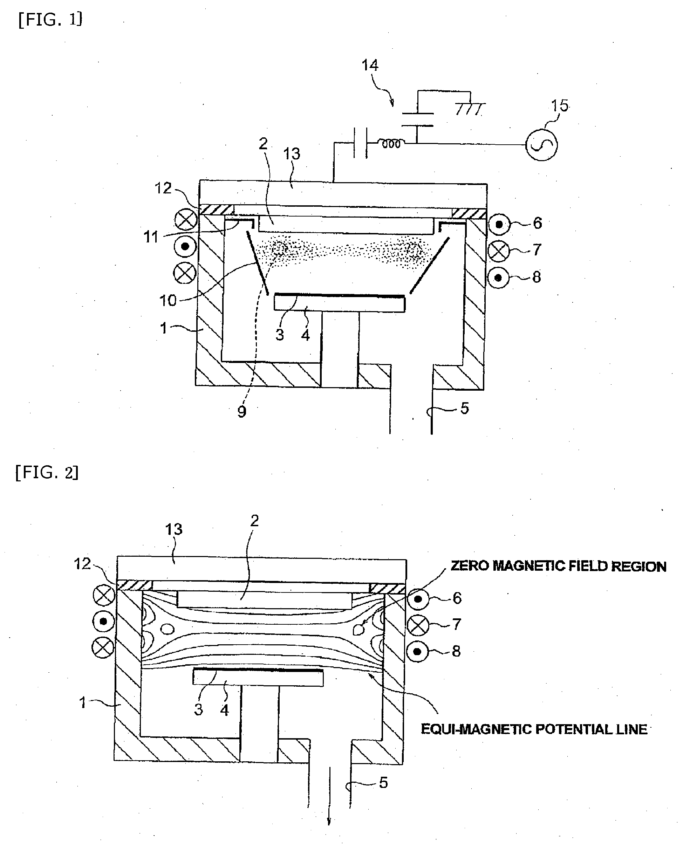

FIG 1 is a schematic illustration of an embodiment of capacitive-coupled magnetic neutral loop plasma sputtering system according to the present invention, showing the configuration thereof In the illustrated system, 1 denotes a vacuum chamber in which a target 2 and a substrate 3 are arranged oppositely to face each other and the substrate 3 is mounted on a substrate holder 4. The vacuum chamber 1 is connected to an appropriate exhaust pump (not shown) by way of an exhaust port 5.

As shown, three electromagnetic coils 6, 7 and 8 are arranged outside the lateral wall of the vacuum chamber 1 and constant electric currents are respectively made to flow through the upper and lower electromagnetic coils 6 and 8 in the same direction, whereas a constant current is made to flow through the intermediate electromagnetic coil 7 in the opposite direction. As a result, a continuous zero magnetic field region is formed in the vacuum chamber 1 at the level of the intermediate electromagnetic coil 7 to form a magnetic neutral loop 9 as seen from the magnetic potential contour map in FIG 2. According to the present invention, the intensities of the electric currents that are respectively made to flow through the three electromagnetic coils 6, 7 and 8 are so selected als to make the intensity of the magnetic field equal to 2 gausses within 1 cm from the zero magnetic field region. The position and the size of the magnetic neutral loop 9 can be selected appropriately by changing the ratio of the electric currents that are respectively made to flow through the upper, intermediate and lower electromagnetic coils 6, 7 and 8. The magnetic neutral loop 9 is pushed down toward the electromagnetic coil 8 when the intensity of the electric current flowing through the upper electromagnetic coil 6 is made greater than the intensity of the electric current flowing through the lower electromagnetic coil 8, whereas the magnetic neutral loop 9 is pushed up toward the electromagnetic coil 6 when the intensity of the electric current flowing through the upper electromagnetic coil 6 is made smaller than the intensity of the electric current flowing through the lower electromagnetic coil 8. The diameter of the magnetic neutral loop 9 is reduced and, at the same time, the magnetic field gradient becomes milder in the zero magnetic field region as the electric current that flows through the intermediate electromagnetic coil 7 is increased.

Deposition preventing members 10, 11 are arranged oppositely relative to each other with the region between the target 2 and the substrate 3 interposed between them in the vacuum chamber 1. On the other hand, a conductive ceiling board 13 is fitted to the top edge of the vacuum chamber 1 by way of an insulator 12 to airtightly seal and ensure vacuum in the vacuum chamber 1. The ceiling board 13 is connected to a high-frequency power source 15 by way of a matching box 14 so as to operate as a cathode electrode. The frequency of the high-frequency power source 15 is 20 to 100 MHz.

Normal lines relative to the magnetic potential contour lines of the magnetic field produced by the electromagnetic coils 6, 7 and 8 in the vacuum chamber 1 as illustrated in FIG. 2 show the directions of lines of magnetic force. A region of zero magnetic field is produced in the inside of the electromagnetic coil 7 as the magnetic field tends to negate itself Electrons generated in the vicinity of the zero magnetic field gather in the zero magnetic field due to the gradB drift. The extent of the gathering depends on the magnetic field gradient in the vicinity of the zero magnetic field. Equilibrium of electrons is established in the plasma in the course of generation, residence and extinction of electrons.

To produce high-density plasma under low pressure, it is necessary to raise the efficiency of generation and minimize the extinction of electrons. Given the efficiency of generation, high-density plasma can be produced by reducing the extinction of electrons. The magnetic field gradient takes the role of reducing the extinction of electrons. As the magnetic field gradient is raised, a large group of electrons tends to gather in the vicinity of the zero magnetic field to make it difficult to realize uniform sputtering. However, the non-uniformity of sputtering is negligible if compared with the magnetron discharge.

Another way for forming high-density plasma is to raise the efficiency of generation of electrons. CCP plasma can be sustained as secondary electrons are generated from the substrate 3 and the plasma sheath is heated at the sheath edge. In view of that the probability of emission of secondary electrons of metal is about 0.2, although it depends on the material of the target 2, it is safe to assume that CCP plasma can be sustained mainly by a heating the sheath. Heating the sheath means that the electric potential of the plasma in the vacuum chamber fluctuates as the target bias is made to fluctuate by the high-frequency bias and the group of electrons located at the edge of the sheath is accelerated in plasma by the fluctuations. The frequency of heating the sheath rises as the frequency rises to raise the plasma density. This effect is referred to as f square law.

The use of a magnetic field provides another additional advantage that the discharge voltage can be reduced by the electron trapping effect. A pressure level of lower than 1 Pa is required for film formation by sputtering. In other words, sputtering particles are required to fly from the target 2 to the substrate 3 without experiencing any collision. This is a requirement that needs to be indispensably met for forming fine film. The lower limit pressure for electric discharges for conventional CCP sputtering is about 2 Pa and the mean free path as converted to nitrogen molecules is about 3 mm. Flying sputtering particles collide with each other repeatedly not less than ten times before they get to the substrate 3 and clustering of sputtering particles takes place as they fly to form large masses, which then fall onto the substrate 3. The film formed in this way is coarse and rough in quality.

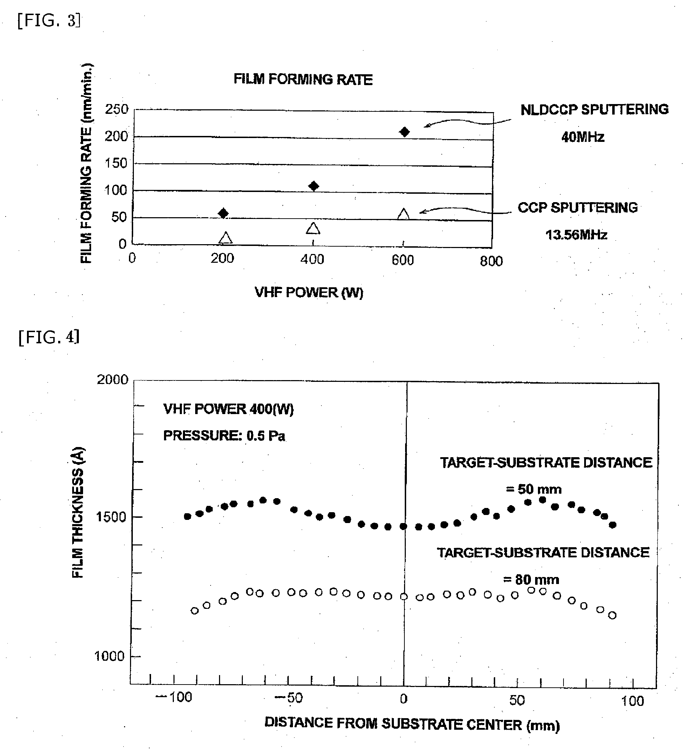

FIG 3 is a graph illustrating the bias power dependency of the film forming rate of a system 1 according to the present invention, when the distance between the target 2 and the substrate 3 is about 80 mm. The pressure is 0.5 Pa in an Ar atmosphere. For the purpose of comparison, the graph also shows the power dependency of the film forming rate of conventional CCP sputtering, using 13.56 MHz.

FIG 4 is a graph illustrating the relationship between the target-substrate distance and the film thickness distribution observed after forming film for 1 minute. The pressure is 0.5 Pa in an Ar atmosphere and electric power of 400W is applied to the target 2. As seen from FIG 4, while the film forming rate rises but the uniformity of the formed film is degraded as the distance between the target 2 and the substrate 3 is reduced.

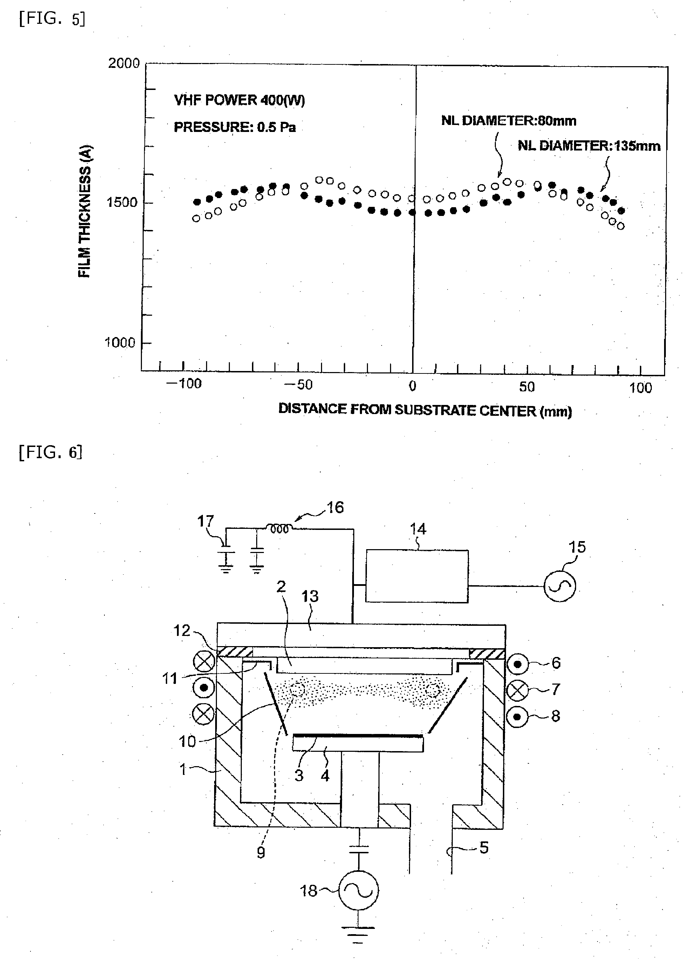

FIG 5 is a graph illustrating the dependency on the diameter of the magnetic neutral loop of the distribution of film deposition in a system according to the present invention. The diameter of the magnetic neutral loop 9 can be changed by changing the electric current flowing through the intermediate coil 5 to consequently change the plasma distribution. While the distribution of erosion is sensitive to the diameter of the magnetic neutral loop 9, the distribution of film deposition is relatively insensitive to the diameter of the magnetic neutral loop 9 so that the sputtering process can be conducted mainly by taking the region of erosion into consideration.

In view of the above description, high-density plasma can be produced by increasing the quantity of electrons confined in the vicinity of the zero magnetic field to provide a sputtering system showing a high efficiency of utilization of target and adapted to a large sputtering area.

FIG 6 is a schematic illustration of another embodiment of capacitive-coupled magnetic neutral loop plasma sputtering system according to the present invention, showing the configuration thereof In FIG 6, the components that correspond to those of the system of the embodiment of FIG 1 are denoted respectively by the same reflectance symbols. Referring to FIG 6, a target 2 and a substrate 3 are arranged oppositely to face each other in a vacuum chamber 1 and the substrate 3 is mounted on a substrate holder 4. The vacuum chamber 1 is connected to an appropriate exhaust pump (not shown) by way of an exhaust port 5.

As shown, three electromagnetic coils 6, 7 and 8 are arranged outside the lateral wall of the vacuum chamber 1 and constant electric currents are respectively made to flow through the upper and lower electromagnetic coils 6 and 8 in the same direction, whereas a constant current is made to flow through the intermediate electromagnetic coil 7 in the opposite direction. As a result, a continuous zero magnetic field region is formed in the vacuum chamber 1 at the level of the intermediate coil 7 to form a magnetic neutral loop 9 as seen from the magnetic potential contour map in FIG 2. According to the present invention, the intensities of the electric currents that are respectively made to flow through the three electromagnetic coils 6, 7 and 8 are so selected as to make the intensity of the magnetic field equal to 2 gausses within 1cm from the zero magnetic field region. The position and the size of the magnetic neutral loop 9 can be selected appropriately by changing the ratio of the electric currents that are respectively made to flow through the upper, intermediate and lower electromagnetic coils 6, 7 and 8. The magnetic neutral loop 9 is pushed down toward the electromagnetic coil 8 when the intensity of the electric current flowing through the upper electromagnetic coil 6 is made greater than the intensity of the electric current flowing through the lower electromagnetic coil 8, whereas the magnetic neutral loop 9 is pushed up toward the electromagnetic coil 6 when the intensity of the electric current flowing through the upper electromagnetic coil 6 is made smaller than the intensity of the electric current flowing through the lower electromagnetic coil 8. The diameter of the magnetic neutral loop 9 is reduced and, at the same time, the magnetic field gradient becomes milder in the zero magnetic field region as the electric current that flowing through the intermediate electromagnetic coil 7 is increased.

Deposition preventing members 10 and 11 are arranged oppositely relative to each other with the region between the target 2 and the substrate 3 interposed between them in the vacuum chamber 1. On the other hand, a conductive ceiling board 13 is fitted to the top edge of the vacuum chamber 1 by way of an insulator 12 to airtightly seal and ensure vacuum in the vacuum chamber 1. The ceiling board 13 is connected to a high-frequency power source 15 by way of a matching box 14 at one hand and to a direct current source 17 by way of a high-frequency filter 16 at the other so that the DC voltage from the direct current source 17 is superposed on the high-frequency power from the high-frequency power source 15 before they are applied to the conductive ceiling board 15. The frequency of the high-frequency power source 15 is 20 to 100 MHz.

Additionally, a high-frequency bias power 18 is connected to the substrate holder 4 on which the substrate 3 is mounted in the embodiment of FIG 6. The high-frequency bias power 18 applies a high-frequency bias of 40 to 100MHz to the substrate 3.

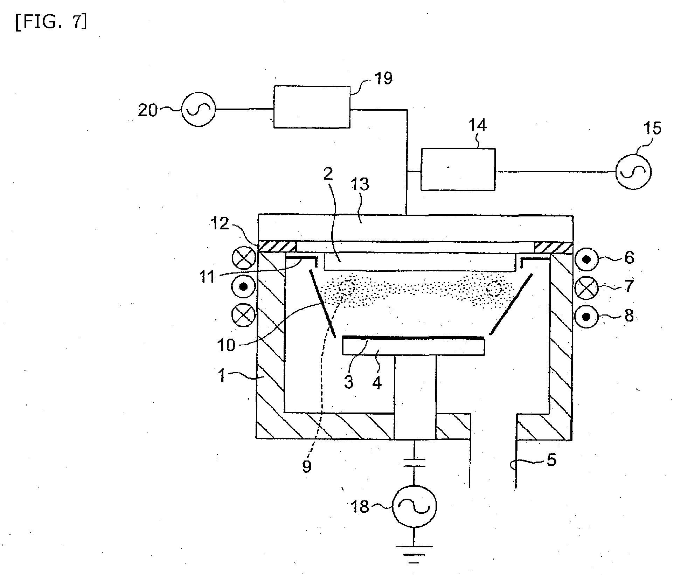

FIG 7 is a schematic illustration of still another embodiment of capacitive-coupled magnetic neutral loop plasma sputtering system according to the present invention, showing the configuration thereof In the system shown in FIG. 7, the components that correspond to those of the system of the embodiment of FIG. 1 are denoted respectively by the same reflectance symbols. Referring to FIG 7, a target 2 and a substrate 3 are arranged oppositely to face each other in a vacuum chamber 1 and the substrate 3 is mounted on a substrate holder 4. The vacuum chamber 1 is connected to an appropriate exhaust pump (not shown) by way of an exhaust port 5.

As shown, three electromagnetic coils 6, 7 and 8 are arranged outside the lateral wall of the vacuum chamber 1 and constant electric currents are respectively made to flow through the upper and lower electromagnetic coils 6 and 8 in the same direction, whereas a constant current is made to flow through the intermediate electromagnetic coil 7 in the opposite direction. As a result, a continuous zero magnetic field region is formed in the vacuum chamber 1 at the level of the intermediate coil 7 to form a magnetic neutral loop 9 as seen from the magnetic potential contour map in FIG 2. According to the present invention, the intensities of the electric currents that are respectively made to flow through the three electromagnetic coils 6, 7 and 8 are so selected as to make the intensity of the magnetic field equal to 2 gausses within 1cm from the zero magnetic field region. The position and the size of the magnetic neutral loop 9 can be selected appropriately by changing the ratio of the electric currents that are respectively made to flow through the upper, intermediate and lower electromagnetic coils 6, 7 and 8. The magnetic neutral loop 9 is pushed down toward the electromagnetic coil 8 when the intensity of the electric current flowing through the upper electromagnetic coil 6 is made greater than the intensity of the electric current flowing through the lower electromagnetic coil 8, whereas the magnetic neutral loop 9 is pushed up toward the electromagnetic coil 6 when the intensity of the electric current flowing through the upper electromagnetic coil 6 is made smaller than the intensity of the electric current flowing through the lower electromagnetic coil 8. The diameter of the magnetic neutral loop 9 is reduced and, at the same time, the magnetic field gradient becomes milder in the zero magnetic field region as the electric current that flows through the intermediate electromagnetic coil 7 is increased.

Deposition preventing members 10, 11 are arranged oppositely relative to each other with the region between the target 2 and the substrate 3 interposed between them in the vacuum chamber 1 in the illustrated embodiment. On the other hand, a conductive ceiling board 13 is fitted to the top edge of the vacuum chamber 1 by way of an insulator 12 to airtightly seal and ensure vacuum in the vacuum chamber 1. The ceiling board 13 is connected to a high-frequency power source 15 by way of a matching box 14 at one hand and to a low-frequency power source 20 by way of another matching box 19 so that the low-frequency voltage from the low-frequency voltage source 20 is superposed on the high-frequency power from the high-frequency power source 15 before they are applied to the conductive ceiling board 15. The frequency of the high-frequency power source 15 is 20 to 100 MHz, and a frequency low-frequency power source 20 is 100 kHz to 4 MHz.

Additionally, a high-frequency bias power 18 is connected to the substrate holder 4 on which the substrate 3 is mounted in the embodiment of FIG 7 as in the case of the embodiment of FIG. 6. The high-frequency bias power 18 applies a high-frequency bias power of 40 to 100 MHz to the substrate 3.

In the systems of FIGS. 6 and 7, the operation of each of the components and the conditions of operation thereof can be selected appropriately as described above for the embodiment of FIG 1. The operation, the function and the advantages of each of the systems of FIGS. 6 and 7 are substantially same as those described above for the embodiment of FIG. 1 by referring to FIGS. 3 through 5.

### Explanation of Reflectance Symbols

- 1:: vacuum chamber
- 2:: target
- 3:: substrate
- 4:: substrate holder
- 5:: exhaust port
- 6:: electromagnetic coil
- 7:: electromagnetic coil
- 8:: electromagnetic coil
- 9:: magnetic neutral loop
- 10:: deposition preventing member
- 11:: deposition preventing member
- 12:: insulator
- 13;: conductive ceiling board
- 14:: matching box
- 15:: high-frequency power source
- 16:: high-frequency filter
- 17:: direct current source
- 18:: high-frequency bias power
- 19:: matching box
- 20:: low-frequency power source

## Claims

1. A capacitive-coupled magnetic neutral loop orneutral loop discharge-NLD plasma sputtering system comprising:
a vacuum chamber (1);
a target (2) placed oppositely relative to a substrate (3) in the vacuum chamber (1);
a magnetic field generation means (6, 7, 8) for forming a magnetic neutral loop (9) of zero magnetic field in the vacuum chamber (1); wherein said magnetic field generation means has three cylindrical electromagnetic coils (6, 7, 8) arranged outside the lateral wall of the vacuum chamber (1), the upper and lower electromagnetic coils (6, 8) are intended to flow constant electric currents in the same; direction and the intermediate electromagnetic coil (7) is intended to flow constant electric current in the opposite direction, the magnetic field generation means is arranged so that the magnetic neutral loop (9) has a diameter which can be changed by changing the electric current flowing through the intermediate electromagnetic coil (7),
and an electric field generation means (13, 15) for generating plasma along the magnetic neutral loop (9) by applying a high-frequency bias to the target (2);
**characterized in that**
the electric field generation means has a conductive ceiling board (13) fitted to the top edge of the vacuum chamber (1) by way of an insulator (12) to airtightly seal and ensure vacuum in the vacuum chamber (1) and a high-frequency power source (15) connected to said ceiling board (13),
the target (2) is fitted to the inner surface of the conductive ceiling board (13) which is an electrode for introducing the electric field into the magnetic neutral loop and operates as a cathode electrode,
the wall of the vacuum chamber is formed by material other than a dielectric, and
the magnetic field gradient being set at 2 gauss/cm or more within 1 cm from the zero magnetic field region for sputtering said target by plasma and forming film on the substrate (3) placed oppositely relative to said target (2).

2. A system according to claim 1, wherein
the frequency of electric power applied to said electric field generation means (13, 15) is not less than 13.56 MHz.

3. A system according to claim 1, wherein
the frequency of electric power applied to said electric field generation means (13, 15) is not less than 20 MHz.

4. A system according to claim 1,
wherein said target (2) is a metal target.

5. A system according to claim 1, wherein it further comprises:
an RF power source (18) connected to a substrate holder (4) for placing said substrate (3) in position and applying a bias to said substrate (3).

6. A system according to claim 1, wherein it further comprises:
a DC power source (17) connected to said target (2) placed in position in said system to superpose a DC voltage.

7. A system according to claim 6, wherein
said DC power source (17) is connected to said ceiling board (13) by way of a high-frequency filter (16).

8. A system according to claim 1, wherein it further comprises:
a low-frequency generation means (19, 20) connected to said target (2) placed in position in said system to superpose a low-frequency bias onto said target (2).

9. A system according to claim 8, wherein
said low-frequency generation means may has a low-frequency power source (20) and a matching unit (19) for connecting said low-frequency power source (20) to said ceiling board (13).

10. A system according to claim 1, wherein it further comprises:
deposition preventing members (10, 11) arranged in said vacuum chamber (1) so as to surround the region between said target (2) and said substrate (3).

## Patentansprüche

1. Sputtersystem mit kapazitiv gekoppeltem Magnetneutralschleifen- oder Neutralschleifenentladungs-NLD-Plasma, umfassend:
eine Vakuumkammer (1);
ein Target (2), das in der Vakuumkammer (1) einem Substrat (3) gegenüberliegend angeordnet ist;
ein Magnetfelderzeugungsmittel (6, 7, 8) zum Erzeugen einer Magnetneutralschleife (9) eines Nullmagnetfeldes in der Vakuumkammer (1); wobei das Magnetfelderzeugungsmittel drei zylindrische elektromagnetische Spulen (6, 7, 8) hat, die außerhalb der Seitenwand der Vakuumkammer (1) angeordnet sind, die obere und die untere elektromagnetischen Spule (6, 8) dafür bestimmt ist, konstante elektrische Ströme in der gleichen Richtung fließen zu lassen, und die dazwischenliegende elektromagnetische Spule (7) dafür bestimmt ist, konstanten elektrischen Strom in die entgegengesetzte Richtung fließen zu lassen,
das Magnetfelderzeugungsmittel so angeordnet ist, dass die Magnetneutralscheife (9) einen Durchmesser hat, der durch Ändern des durch die dazwischenliegende elektromagnetische Spule (7) fließenden elektrischen Stroms geändert werden kann;
und ein zur Erzeugung eines elektrischen Feldes bestimmtes Mittel (13, 15) zum Erzeugen von Plasma entlang der Magnetneutralschleife (9) durch Beaufschlagen des Targets (2) mit einer Hochfrequenzvormagnetisierung;
**dadurch gekennzeichnet, dass**
das zur Erzeugung des elektrisches Feldes bestimmte Mittel eine leitende Deckenplatte (13), die mittels eines Isolators (12) zur luftdichten Abdichtung und Sicherstellung des Vakuums in der Vakuumkammer (1) mittels eines Isolators (12) an der Oberkante der Vakuumkammer (1) angebracht ist, und eine Hochfrequenzleistungsquelle (15) hat, die mit der Deckenplatte (13) verbunden ist,
das Target (2) an der Innenfläche der leitenden Deckenplatte (13) angebracht ist, die eine Elektrode zum Einbringen des elektrischen Feldes in die Magnetneutralschleife ist und als Kathodenelektrode wirkt,
die Wand der Vakuumkammer aus einem anderen Material als einem dielektrischen Material gebildet ist, und
der Magnetfeldgradient auf 2 Gauß/cm oder mehr innerhalb 1 cm von dem Nullmagnetfeldbereich zum Sputtern des Targets mit Plasma und zum Erzeugen eines Films auf dem dem Target (2) gegenüberliegend angeordneten Substrat (3) eingestellt ist.

2. System nach Anspruch 1, wobei
die Frequenz der elektrischen Leistung, die an das zur Erzeugung des elektrischen Feldes bestimmte Mittel (13, 15) angelegt wird, nicht kleiner als 13,56 MHz ist.

3. System nach Anspruch 1, wobei
die Frequenz der elektrischen Leistung, die an das zur Erzeugung des elektrischen Feldes bestimmte Mittel (13, 15) angelegt wird, nicht kleiner als 20 MHz ist.

4. System nach Anspruch 1,
wobei das Target (2) ein Metalltarget ist.

5. System nach Anspruch 1, wobei es ferner umfasst:
eine RF-Leistungsquelle (18), die mit einem Substrathalter (4) zum Positionieren des Substrats (3) verbunden ist und eine Vorspannung an das Substrat (3) anlegt.

6. System nach Anspruch 1, wobei es ferner umfasst:
eine Gleichstromquelle (17), die mit dem in dem System positionierten Target (2) zur Überlagerung einer Gleichspannung verbunden ist.

7. System nach Anspruch 6, wobei
die Gleichstromquelle (17) mittels eines Hochfrequenzfilters (16) mit der Deckenplatte (13) verbunden ist.

8. System nach Anspruch 1, wobei es
ferner umfasst:
ein Niederfrequenzerzeugungsmittel (19, 20), das mit dem in dem System positionierten Target (2) verbunden ist, um dem Target (2) eine Niederfrequenzvorspannung zu überlagern.

9. System nach Anspruch 8, wobei
das Niederfrequenzerzeugungsmittel ein Niederfrequenzleistungsquelle (20) und eine Anpasseinheit (19) zum Verbinden der Niederfrequenzleistungsquelle (20) mit der Deckenplatte (13) hat.

10. System nach Anspruch 1, wobei es ferner umfasst:
Beschichtungsverhinderungsmittel (10, 11), die in der Vakuumkammer (1) angeordnet sind, um den Bereich zwischen dem Target (2) und dem Substrat (3) zu umschließen.

## Revendications

1. Système de pulvérisation plasma par décharge à boucle neutre (NLD) ou à boucle neutre magnétique à couplage capacitif comprenant :
une chambre à vide (1),
une cible (2) placée en face d'un substrat (3) dans la chambre à vide (1) ;
des moyens générateurs de champ magnétique (6, 7, 8) pour former une boucle neutre magnétique (9) de champ magnétique zéro dans la chambre à vide (1), dans lequel lesdits moyens générateurs de champ magnétique possèdent trois bobines électromagnétiques cylindriques (6, 7, 8) agencées à l'extérieur de la paroi latérale de la chambre à vide (1), les bobines électromagnétiques supérieure et inférieure (6, 8) étant destinées à faire circuler des courants électriques constants dans le même sens et la bobine électromagnétique intermédiaire (7) étant destinée à faire circuler un courant électrique constant dans le sens opposé,
les moyens générateurs de champ magnétique sont agencés de telle manière que la boucle neutre magnétique (9) a un diamètre qui peut être modifié en changeant le courant électrique qui circule à travers la bobine électromagnétique intermédiaire (7), et
un moyen générateur de champ électrique (13, 15) pour générer le plasma le long de la boucle neutre magnétique (9) par application d'une polarisation haute fréquence à la cible (2) ;
**caractérisé en ce que**
le moyen générateur de champ électrique possède un panneau de plafond conducteur (13) installé sur le bord supérieur de la chambre à vide (1) grâce à un isolant (12) afin de la rendre étanche à l'air et d'assurer le vide dans la chambre à vide (1) et une source d'énergie haute fréquence (15) connectée au dit panneau de plafond (13),
la cible (2) est installée sur la surface interne du panneau de plafond conducteur (13) qui est une électrode pour introduire le champ électrique dans la boucle neutre magnétique et fonctionne comme une électrode cathodique,
la paroi de la chambre à vide est construite en un matériau autre qu'un diélectrique, et
le gradient du champ magnétique étant réglé à 2 gauss/cm ou plus à moins de 1 cm de la zone de champ magnétique zéro pour pulvériser ladite cible avec le plasma, et former un film sur le substrat (3) placé en face de ladite cible (2).

2. Système selon la revendication 1, dans lequel
- la fréquence du courant électrique appliqué aux dits moyens générateurs de champ électrique (13, 15) n'est pas inférieure à 13,56 MHz.

3. Système selon la revendication 1, dans lequel
- la fréquence du courant électrique appliqué aux dits moyens générateurs de champ électrique (13, 15) n'est pas inférieure à 20 MHz.

4. Système selon la revendication 1, dans lequel
- ladite cible (2) est une cible métallique.

5. Système selon la revendication 1, qui comprend en outre :
- une source de courant RF (18) connectée à un support de substrat (4) afin de placer ledit substrat (3) en position et d'appliquer une polarisation au dit substrat (3).

6. Système selon la revendication 1, qui comprend en outre :
- une source de courant CC (17) connectée à ladite cible (2) placée en position dans ledit système afin de superposer une tension CC.

7. Système selon la revendication 6, dans lequel
- ladite source de courant CC (17) est connectée avec ledit panneau de plafond (13) par l'intermédiaire d'un filtre haute fréquence (16).

8. Système selon la revendication 1, qui comprend en outre :
- des moyens générateurs basse fréquence (19, 20) connectés à ladite cible (2) placée en position dans ledit système afin de superposer une polarisation basse fréquence sur ladite cible (2).

9. Système selon la revendication 8, dans lequel
- lesdits moyens générateurs basse fréquence peuvent avoir une source de courant basse fréquence (20) et une unité d'adaptation (19) permettant de connecter ladite source de courant basse fréquence (20) au dit panneau de plafond (13).

10. Système selon la revendication 1, qui comprend en outre :
- des organes destinés à empêcher les dépôts (10, 11) agencés dans ladite chambre à vide (1) de manière à entourer la région entre ladite cible (2) et ledit substrat (3).
